# EUROPEAN PATENT APPLICATION

(11) **EP 4 596 748 A2**
(43) Date of publication of application: **06.08.2025**
(21) Application number: 24218265.7
(22) Date of filing: 09.12.2024
(51) Int. Cl.: C23C 16/04, C23C 16/455, H01L 21/285

(54) **METHOD OF PROCESSING SUBSTRATE, METHOD OF MANUFACTURING SEMICONDUCTOR DEVICE, SUBSTRATE PROCESSING APPARATUS, AND PROGRAM**

(30) Priority: 13.12.2023 JP 2023209864
(71) Applicant: Kokusai Electric Corporation, Tokyo 101-0045 (JP)
(72) Inventor: NONOMURA, Kazuki, Toyama-shi, Toyama, 939-2393 (JP)
(74) Representative: Bardehle Pagenberg Partnerschaft mbB Patentanwälte Rechtsanwälte

(57) **Abstract**

There is provided a technique that includes performing a first cycle of forming a layer containing a first element and a second element, the first cycle including performing: (a) supplying a first precursor gas containing the first element to a substrate (200) including a recess on a surface of the substrate (200); (b) supplying a first adsorption inhibitor gas to the substrate (200); (c) supplying a second precursor gas containing the second element, different from the first element, to the substrate (200); and (d) supplying a reactant gas to the substrate (200), wherein a functional group formed on the substrate (200) in (a) and (b) inhibits adsorption of the second precursor gas on the substrate (200), and wherein in at least a part of (c), the second precursor gas is supplied to the substrate (200) on which the first precursor gas and the first adsorption inhibitor gas are adsorbed.

## Description

### CROSS-REFERENCE TO RELATED APPLICATION

This application is based upon and claims the benefit of priority from Japanese Patent Application No. 2023-209864, filed on December 13, 2023, the entire contents of which are incorporated herein by reference.

### TECHNICAL FIELD

The present disclosure relates to a method of processing a substrate, a method of manufacturing a semiconductor device, a substrate processing apparatus, and a program.

### BACKGROUND

As one step in the substrate processing process (the manufacturing process of semiconductor devices), a film may be formed on a surface of a substrate by using a substance that inhibits adsorption of other substances to the substrate.

### SUMMARY

Some embodiments of the present disclosure provide a technique capable of improving uniformity of a film formed on a surface of a substrate.

According to embodiments of the present disclosure, there is provided a technique that includes performing a first cycle of forming a layer containing a first element and a second element, the first cycle including performing: (a) supplying a first precursor gas containing the first element to a substrate including a recess on a surface of the substrate; (b) supplying a first adsorption inhibitor gas to the substrate; (c) supplying a second precursor gas containing the second element, different from the first element, to the substrate; and (d) supplying a reactant gas to the substrate, wherein a functional group formed on the substrate in (a) and (b) inhibits adsorption of the second precursor gas on the substrate, and wherein in at least a part of (c), the second precursor gas is supplied to the substrate on which the first precursor gas and the first adsorption inhibitor gas are adsorbed.

### BRIEF DESCRIPTION OF DRAWINGS

The accompanying drawings, which are incorporated in and constitute a part of the specification, illustrate embodiments of the present disclosure.
FIG. 1 is a schematic configuration diagram of a vertical process furnace of a substrate processing apparatus, in which a portion of the process furnace is illustrated in a vertical cross-sectional view.
FIG. 2 is a schematic configuration diagram of the vertical process furnace of the substrate processing apparatus, in which a portion of the process furnace is illustrated in a cross-sectional view taken along line A-A in FIG. 1.
FIG. 3 is a schematic configuration diagram of a controller of the substrate processing apparatus, in which a control system of the controller is illustrated in a block diagram.
FIG. 4 is a diagram illustrating a process sequence according to embodiments of the present disclosure.
FIG. 5A is a partially enlarged cross-sectional view of a surface of a wafer on which a first precursor gas is adsorbed. FIG. 5B is a partially enlarged cross-sectional view of the surface of the wafer 200 on which the first precursor gas and a first adsorption inhibitor gas are adsorbed. FIG. 5C is a partially enlarged cross-sectional view of the surface of the wafer 200 on which the first precursor gas, the first adsorption inhibitor gas, and a second precursor gas are adsorbed.
FIG. 6A is a diagram illustrating an example of a process sequence in Modification 1. FIG. 6B is a diagram illustrating an example of a process sequence in Modification 1. FIG. 6C is a diagram illustrating an example of a process sequence in Modification 1. FIG. 6D is a diagram illustrating an example of a process sequence in Modification 1.
FIG. 7A is a diagram illustrating an example of a process sequence in Modification 2. FIG. 7B is a diagram illustrating an example of a process sequence in Modification 2. FIG. 7C is a diagram illustrating an example of a process sequence in Modification 2. FIG. 7D is a diagram illustrating an example of a process sequence in Modification 2.
FIG. 8 is a diagram illustrating a process sequence in Modification 3.
FIG. 9 is a diagram illustrating a process sequence in Modification 4.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

### <Embodiments of Present Disclosure>

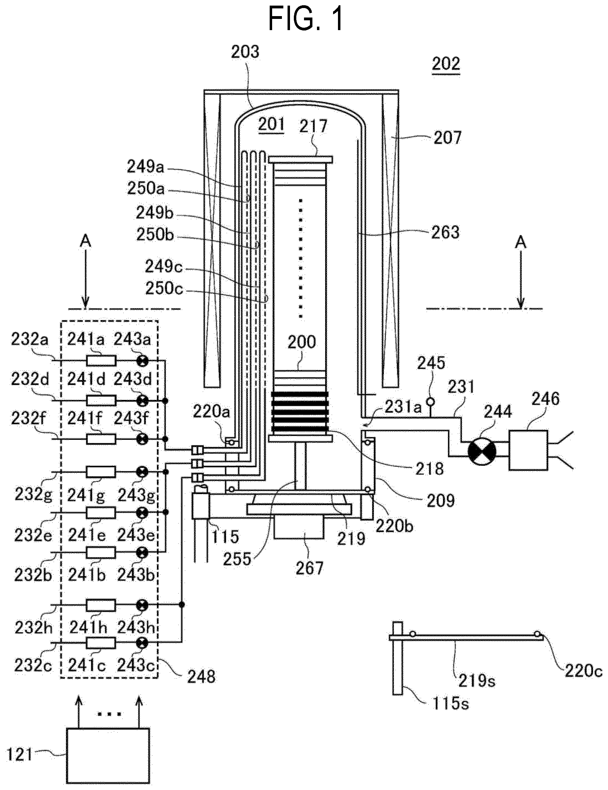

Hereinafter, embodiments of the present disclosure are described mainly with reference to FIGS. 1 to 4 and FIGS. 5A to 5C. In addition, the drawings used in the following description are schematic, and dimensional relationships between respective components and the proportions of respective components illustrated in the drawings may not correspond to those in reality. Further, the dimensional relationships between respective elements and the proportions of respective elements may not match among multiple drawings.

### (1) Configuration of Substrate Processing Apparatus

As illustrated in FIG. 1, a process furnace 202 includes a heater 207 serving as a temperature regulator (heating part). The heater 207 also functions as an activator (exciter) that activates (excites) a gas with heat.

A reaction tube 203 is disposed inside the heater 207. A manifold 209 is disposed below the reaction tube 203, and an O-ring 220a serving as a seal is provided between the manifold 209 and the reaction tube 203. A process container (reaction container) mainly includes the reaction tube 203 and the manifold 209. A process chamber 201 is formed in an interior of the process container. The process chamber 201 is configured to be capable of accommodating a wafer 200 serving as a substrate. The wafer 200 is processed within the process chamber 201.

Nozzles 249a to 249c are installed, respectively, as first to third suppliers within the process chamber 201. The nozzles 249a to 249c are also referred to as first to third nozzles, respectively. Gas supply pipes 232a to 232c are connected to the nozzles 249a to 249c, respectively.

The gas supply pipes 232a to 232c are installed, respectively, with mass flow controllers (MFCs) 241a to 241c, which serve as flow-rate controllers (flow-rate control parts), and valves 243a to 243c, which serve as opening/closing valves, in order from an upstream of a gas flow. Gas supply pipes 232d and 232f are connected, respectively, to the gas supply pipe 232a at a downstream of the valve 243a. Gas supply pipes 232e and 232g are connected, respectively, to the gas supply pipe 232b at a downstream of the valve 243b. A gas supply pipe 232h is connected to the gas supply pipe 232c at a downstream of the valve 243c. The gas supply pipes 232d to 232h are provided, respectively, with MFCs 241d to 241h and valves 243d to 243h in order from an upstream of a gas flow.

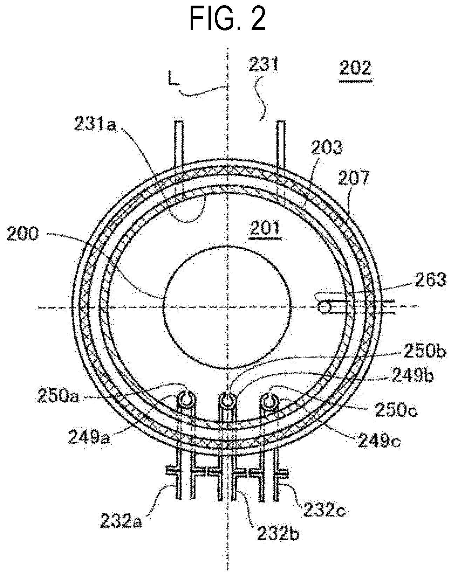

As illustrated in FIG. 2, the nozzles 249a to 249c are installed, respectively, in a space between an inner wall of the reaction tube 203 and the wafer 200. The nozzles 249a and 249c are disposed on both sides of a straight line L passing through a center of the nozzle 249b and an exhaust port 231a. Gas supply holes 250a to 250c through which gases are supplied toward the wafer 200 are formed, respectively, on the nozzles 249a to 249c. The gas supply holes 250a to 250c are formed in plural from a bottom to a top of the respective nozzles 249a to 249c.

A first precursor gas (first precursor) is supplied into the process chamber 201 through the gas supply pipe 232a, MFC 241a, valve 243a, and nozzle 249a.

A second precursor gas (second precursor) is supplied into the process chamber 201 through the gas supply pipe 232b, MFC 241b, valve 243b, and nozzle 249b.

A reactant gas (reactant) is supplied into the process chamber 201 through the gas supply pipe 232c, MFC 241c, valve 243c, and nozzle 249c.

A first adsorption inhibitor gas (first inhibitor) is supplied into the process chamber 201 through the gas supply pipe 232d, MFC 241d, valve 243d, gas supply pipe 232a, and nozzle 249a. Herein, the first adsorption inhibitor gas is a gas that inhibits the second precursor gas from being adsorbed on the wafer 200.

A second adsorption inhibitor gas (second inhibitor) is supplied into the process chamber 201 through the gas supply pipe 232e, MFC 241e, valve 243e, gas supply pipe 232b, and nozzle 249b. Herein, the second adsorption inhibitor gas is a gas that inhibits the first precursor gas from being adsorbed on the wafer 200.

An inert gas is supplied into the process chamber 201 through the respective gas supply pipes 232f to 232h, MFCs 241f to 241h, valves 243f to 243h, gas supply pipes 232a to 232c, and nozzles 249a to 249c. The inert gas acts as a purge gas, a carrier gas, a dilution gas, and others.

A first precursor gas supply system mainly includes the gas supply pipe 232a, MFC 241a, and valve 243a. A second precursor gas supply system mainly includes the gas supply pipe 232b, MFC 241b, and valve 243b. A reactant gas supply system mainly includes the gas supply pipe 232c, MFC 241c, and valve 243c. A first adsorption inhibitor gas supply system mainly includes the gas supply pipe 232d, MFC 241d, and valve 243d. A second adsorption inhibitor gas supply system mainly includes the gas supply pipe 232e, MFC 241e, and valve 243e. An inert gas supply system mainly includes the gas supply pipes 232f to 232h, MFCs 241f to 241h, and valves 243f to 243h. The nozzles connected to the gas supply pipes constituting the various supply systems described above may be included, respectively, in those supply systems.

Any of or the entire various supply systems described above may be configured as an integrated supply system 248 where the valves 243a to 243h, MFCs 241a to 241h, and others are integrated. The integrated supply system 248 is connected to each of the gas supply pipes 232a to 232h, and is configured to control, by a controller 121 to be described later, the supply operations of various substances (various gases) into the gas supply pipes 232a to 232h such as the opening/closing operations of the valves 243a to 243h and the flow rate regulation operations of the MFCs 241a to 241h.

The exhaust port 231a is provided at a lower side of a sidewall of the reaction tube 203 and is connected to an exhaust pipe 231 to exhaust the atmosphere in the process chamber 201. The exhaust pipe 231 is connected to a vacuum pump 246, which serves as a vacuum exhauster, through a pressure sensor 245, which serves as a pressure detector (pressure detection part) that detects an internal pressure of the process chamber 201, and an auto pressure controller (APC) valve 244, which serves as a pressure regulator (pressure regulation part). The APC valve 244 may perform or stop a vacuum-exhaust in the process chamber 201 by opening and closing the valve while the vacuum pump 246 is operating. The APC valve 244 is further configured to be capable of regulating the internal pressure of the process chamber 201 by adjusting a valve opening degree based on pressure information detected by the pressure sensor 245 while the vacuum pump 246 is operating. An exhaust system mainly includes the exhaust pipe 231, APC valve 244, and pressure sensor 245. The vacuum pump 246 may also be considered as included in the exhaust system.

A seal cap 219 is installed below the manifold 209 and is capable of airtightly closing an opening at a lower end of the manifold 209. An O-ring 220b is provided on an upper surface of the seal cap 219 and serves as a seal abutting against the lower end of the manifold 209. A rotator 267 is installed below the seal cap 219. A rotating shaft 255 of the rotator 267 passes through the seal cap 219 and is connected to a boat 217. The rotator 267 is configured to rotate the wafer 200 by rotating the boat 217. The seal cap 219 is configured to be vertically moved up and down by a boat elevator 115, which serves as a lift installed outside the reaction tube 203. The boat elevator 115 is configured as a transfer apparatus (transfer mechanism) that loads and unloads (transfers) the wafer 200 into and out of the process chamber 201 by moving the seal cap 219 up and down.

A shutter 219s is installed below the manifold 209 and is capable of airtightly closing the opening at the lower end of the manifold 209 in a state where the seal cap 219 is moved down and the boat 217 is unloaded out of the process chamber 201. An O-ring 220c is provided on an upper surface of the shutter 219s and serves as a seal abutting against the lower end of the manifold 209. The opening/closing operation (such as elevating and rotating operations) of the shutter 219s is controlled by a shutter opening/closing mechanism 115s.

The boat 217, which serves as a substrate support, is configured to support, for example, 25 to 200 wafers 200 in a horizontal posture and in multiple stages. In addition, the notation of numerical ranges such as "25 to 200" herein implies that the lower limit value and the upper limit value are included in that range. Thus, for example, "25 to 200" implies "25 or more and 200 or less." This applies similarly to other numerical ranges. Heat insulation plates 218, which are made of, for example, a heat-resistant material such as quartz or SiC, etc., are supported in multiple stages at a bottom of the boat 217.

A temperature sensor 263 is installed as a temperature detector within the reaction tube 203. Regulating a power supplied to the heater 207 based on temperature information detected by the temperature sensor 263 may allow the interior of the process chamber 201 or the wafer 200 to achieve a desired temperature distribution. The temperature sensor 263 is provided along the inner wall of the reaction tube 203.

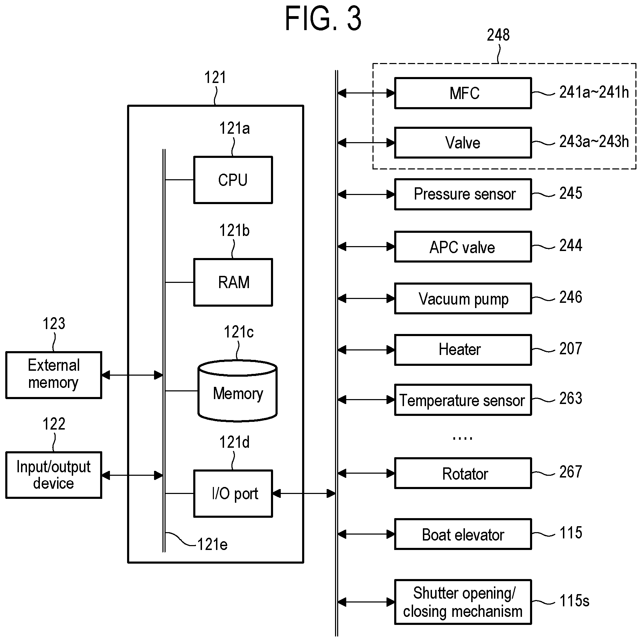

As illustrated in FIG. 3, the controller 121, which is a control part (control means), is configured as a computer including a central processing unit (CPU) 121a, random access memory (RAM) 121b, memory 121c, and I/O port 121d. The RAM 121b, memory 121c, and I/O port 121d are configured to be capable of exchanging data with the CPU 121a through an internal bus 121e. The controller 121 is connected to an input/output device 122, which is formed of, for example, a touch panel and others. Further, an external memory 123 may be connected to the controller 121. In addition, the substrate processing apparatus may be configured to include a single controller or a plurality of controllers. In other words, control for performing a process sequence to be described later may be performed using a single controller or a plurality of controllers. Further, the plurality of controllers may be configured as a control system by being connected to one another through wired or wireless communication networks, and the control for performing the process sequence to be described later may be performed by the entire control system. When the term "controller" is used herein, it may include a single controller, may include a plurality of controllers, or may include a control system composed of a plurality of controllers.

The memory 121c is configured by, for example, a flash memory, a hard disk drive (HDD), a solid state drive (SSD), and others. The memory 121c stores, in a readable manner, a control program for controlling the operation of the substrate processing apparatus, a process recipe including procedures, conditions, etc., of substrate processing to be described later, and others. The process recipe is a combination that causes the controller 121 to execute each procedure of substrate processing to be described later, in the substrate processing apparatus, to obtain predetermined results, and functions as a program. Hereinafter, the process recipe, control program, and others are collectively referred to simply as "program." Further, the process recipe is also simply referred to as "recipe." The term "program" as used herein may refer to a case of solely including the recipe, a case of solely including the control program, or a case of including both. The RAM 121b is configured as a memory area (work area) where programs, data, and others read by the CPU 121a are temporarily held.

The I/O port 121d is connected to the above-described MFCs 241a to 241h, valves 243a to 243h, pressure sensor 245, APC valve 244, vacuum pump 246, temperature sensor 263, heater 207, rotator 267, boat elevator 115, shutter opening/closing mechanism 115s, and others.

The CPU 121a is configured to be capable of reading and executing the control program from the memory 121c. The CPU 121a is also configured to be capable of reading the recipe from the memory 121c in response to an input of an operation command and the like from the input/output device 122. The CPU 121a is configured to be capable of, according to contents of the recipe thus read, controlling of the flow rate regulating operations of various substances (various gases) by the MFCs 241a to 241h, the opening/closing operations of the valves 243a to 243h, the opening/closing operation of the APC valve 244, the pressure regulating operation by the APC valve 244 based on the pressure sensor 245, the startup and shutdown of the vacuum pump 246, the temperature regulating operation of the heater 207 based on the temperature sensor 263, the rotation and rotational speed adjusting operation of the boat 217 by the rotator 267, the raising and lowering operation of the boat 217 by the boat elevator 115, the opening/closing operation of the shutter 219s by the shutter opening/closing mechanism 115s, and others.

The controller 121 may be configured by installing the aforementioned program recorded and stored in the external memory 123 onto the computer. The external memory 123 includes, for example, a magnetic disk such as HDD, an optical disk such as CD, a magneto-optical disk such as MO, a semiconductor memory such as USB memory or SSD, and others. The memory 121c and the external memory 123 are configured as computer-readable recording media. Hereinafter, these are collectively referred to simply as "recording medium." The term "recording medium" as used herein may refer to a case of solely including the memory 121c, a case of solely including the external memory 123, or a case of including both. In addition, providing the program to the computer may be done using a communication means such as the Internet or a dedicated line without using the external memory 123.

### (2) Substrate Processing Step

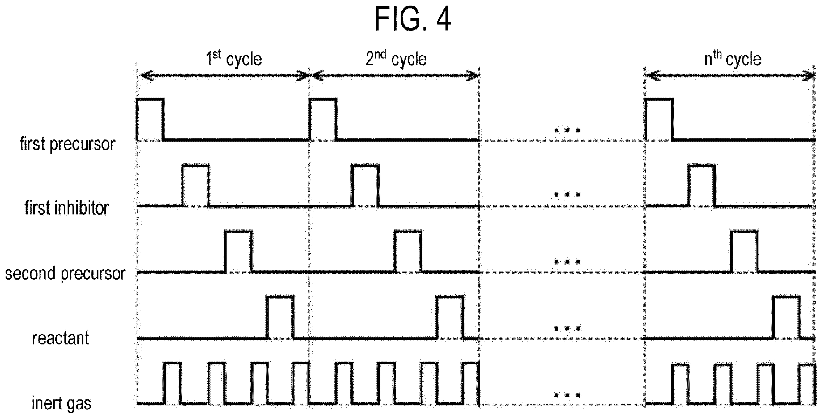

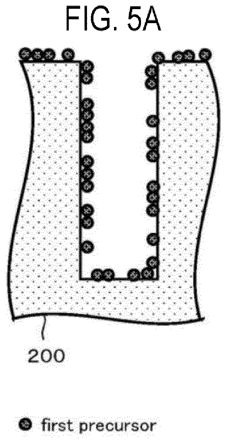

As one step of a manufacturing process of semiconductor devices by using the above-described substrate processing apparatus, a method of processing a substrate, i.e., an example of a process sequence for forming a film on the wafer 200, which serves as a substrate with a three-dimensional structure such as a trench, groove, or hole formed as a recess on a surface thereof, are described mainly with reference to FIGS. 4 and 5A to 5C. In the following description, the operation of each component constituting the substrate processing apparatus is controlled by the controller 121.

The process sequence of the present embodiments includes a first cycle of forming a layer containing a first element and a second element by performing the following steps:
(a) supplying a first precursor gas containing the first element to the wafer 200 including a recess on a surface thereof;
(b) supplying a first adsorption inhibitor gas to the wafer 200;
(c) supplying a second precursor gas containing the second element, different from the first element, to the wafer 200; and
(d) supplying a reactant gas to the wafer 200,

wherein a functional group formed on the wafer 200 in (a) and (b) inhibits adsorption of the second precursor gas on the wafer 200, and
wherein in at least a part of (c), the second precursor gas is supplied to the wafer 200 on which the first precursor gas and the first adsorption inhibitor gas are adsorbed.

As illustrated in FIG. 4, the present embodiments describe a case where a cycle of sequentially performing (a), (b), (c) and (d) is performed a predetermined number of times (n times, where n is an integer greater than or equal to 1).

As illustrated in FIG. 4, the present embodiments describe a case where, throughout (c), the second precursor gas is supplied to the wafer 200, to which the first precursor gas and the first adsorption inhibitor gas are adsorbed.

In the present disclosure, for convenience, the above-described process sequence may also be represented as follows. The same notation is also used in the following description of modifications and other embodiments.(First precursor gas →First adsorption inhibitor gas →Second precursor gas →Reactant gas) × n

In the present disclosure, "→" in the "First precursor gas → First adsorption inhibitor gas" and similar ones indicates that purging is performed to purge the interior of the process chamber 201.

The term "wafer" as used herein may refer to the wafer itself, or a stack including the wafer and a predetermined layer or film formed on a surface of the wafer. The term "surface of a wafer" as used herein may refer to the surface of the wafer itself, or a surface of a predetermined layer and others formed on the wafer. When it is stated herein "a predetermined layer is formed on the wafer," it may mean that the predetermined layer is directly formed on the surface of the wafer itself, or that the predetermined layer is formed on a layer and others formed on the wafer. The term "substrate" as used herein is synonymous with the term "wafer."

The term "layer" as used herein includes at least one selected from the group of a continuous layer or a discontinuous layer. For example, a deposited layer may include a continuous layer, a discontinuous layer, or both.

In the present disclosure, when describing the adsorption or reaction of each of the first precursor gas, first adsorption inhibitor gas, second precursor gas, second adsorption inhibitor gas, and reactant gas to the surface of the wafer 200, it may include a mode in which they are adsorbed on or react with the surface of the wafer 200 in an undecomposed state, as well as a mode in which they decompose or their ligands are desorbed to produce intermediates that are adsorbed on or react with the surface of the wafer 200.

### (Wafer Charging and Boat Loading)

A plurality of wafers 200 are charged (wafer charging) into the boat 217. The shutter 219s is moved by the shutter opening/closing mechanism 115s to open the opening at the lower end of the manifold 209 (shutter-open). Thereafter, the boat 217 supporting the plurality of wafers 200 is lifted by the boat elevator 115 and is loaded (boat loading) into the process chamber 201. In this state, the seal cap 219 seals the lower end of the manifold 209 via the O-ring 220b. In this way, as illustrated in FIG. 1, the wafers 200 are prepared (provided) in the process chamber 201.

### (Pressure Regulation and Temperature Regulation)

After the boat loading is completed, the interior of the process chamber 201, i.e., a space where the wafers 200 exist, is vacuum-exhausted (decompression-exhausted) by the vacuum pump 246 to reach a desired pressure (degree of vacuum). At this time, the internal pressure of the process chamber 201 is measured by the pressure sensor 245, and the APC valve 244 is feedback-controlled based on measured pressure information. Further, the wafers 200 in the process chamber 201 are heated to reach a desired processing temperature by the heater 207. At this time, the power supplied to the heater 207 is feedback-controlled based on temperature information detected by the temperature sensor 263 so as to achieve a desired temperature distribution in the process chamber 201. Further, the rotation of the wafers 200 is initiated by the rotator 267. The vacuum-exhaust of the process chamber 201 and the heating and rotation of the wafers 200 continue at least until the wafers 200 are completely processed.

### (Film-Forming Process)

After that, the following steps A, B, C and D are sequentially executed.

### [Step A]

In this step, the first precursor gas containing the first element is supplied to the wafer 200 in the process chamber 201, i.e., the wafer 200 with the recess on the surface thereof.

Specifically, the valve 243a is opened to flow the first precursor gas into the gas supply pipe 232a. The first precursor gas is regulated in flow rate by the MFC 241a, is supplied into the process chamber 201 through the nozzle 249a, and is exhausted from the exhaust port 231a. At this time, the first precursor gas is supplied to the wafer 200 from a lateral side of the wafer 200 (first precursor gas supply). At this time, the valves 243f to 243h may be opened to supply an inert gas into the process chamber 201 through the respective nozzles 249a to 249c.

A processing condition when supplying the first precursor gas in this step is exemplified as follows:
Processing temperature: 350 to 700 degrees C, particularly 500 to 600 degrees C;
Processing pressure: 1 to 10,000 Pa, particularly 10 to 1,333 Pa;
First precursor gas supply flow rate: 0.01 to 3 slm, particularly 0.1 to 1 slm;
First precursor gas supply time: 10 to 120 seconds, particularly 20 to 60 seconds; and
Inert gas supply flow rate (per gas supply pipe): 0 to 10 slm.

Further, the processing temperature herein refers to a temperature of the wafer 200 or an internal temperature of the process chamber 201, and the processing pressure herein refers to the internal pressure of the process chamber 201. Further, the processing time refers to the time during which the processing is continued. Further, the supply flow rate refers to the flow rate of a gas supplied into the process chamber 201. Further, if the supply flow rate includes 0 slm, "0 slm" refers to a case where no substance (gas) is supplied into the process chamber 201. This applies similarly to the following description.

By supplying the first precursor gas to the wafer 200 under the above-described processing condition, the first precursor gas may be adsorbed on adsorption sites present on the surface of the wafer 200 *(see* FIG. 5A). Specifically, this allows the first precursor gas to be adsorbed discontinuously on at least a portion of an upper surface of the recess and an inner surface of the recess (sidewall surface and bottom surface inside the recess) *(see* FIG. 5A). More specifically, this allows the first precursor gas to be adsorbed discontinuously over the entire surface from an opening side to a deep side of the recess. In addition, the upper surface and inner surface of the recess, on which the first precursor gas is adsorbed, are in a state where a predetermined functional group of the first precursor gas is exposed. Hereinafter, the "opening side of the recess" is referred to as the "opening side," and the "deep side of the recess" is referred to as the "deep side." In addition, in the present disclosure, the "deep side of the recess" refers to, for example, a location and its surrounding area, such as the bottom of the recess, where the gas supplied to the wafer 200 is difficult to reach compared to the opening side.

As for the first precursor gas, for example, silane-based gases containing silicon (Si) as the first element may be used. Examples of the silane-based gases may include gases containing Si and halogens, i.e., halosilane-based gases. The halogens include chlorine (Cl), fluorine (F), bromine (Br), iodine (I), and others. In other words, the halosilane-based gases contain, as functional groups, at least one selected from the halogen groups of chloro (Cl), fluoro (F), bromo (Br), iodine (I) groups, etc.

Examples of the first precursor gas may include chlorosilane-based gases such as monochlorosilane (SiH₃Cl) gas, dichlorosilane (SiH₂Cl₂) gas, trichlorosilane (SiHCl₃) gas, tetrachlorosilane (SiCl₄) gas, hexachlorodisilane (Si₂Cl₆) gas, octachlorotrisilane (Si₃Cl₈) gas, and the like. One or more of these gases may be used as the first precursor gas.

In addition to the chlorosilane-based gases, other examples of the first precursor gas may include fluorosilane-based gases such as tetrafluorosilane (SiF₄) gas, trifluorosilane (SiHF₃) gas, difluorosilane (SiH₂F₂) gas, etc., bromosilane-based gases such as tetrabromosilane (SiBr₄) gas, tribromosilane (SiHBr₃) gas, dibromosilane (SiH₂Br₂) gas, etc., and iodosilane-based gases such as tetraiodosilane (SiI₄) gas, triiodosilane (SiHI₃) gas, diiodosilane (SiH₂I₂) gas, etc. One or more of these gases may be used as the first precursor gas.

Further, for example, gases containing Si as the first element and organic ligands may be used as the first precursor gas. Examples of the gases containing Si and organic ligands may include aminosilane-based gases such as tetrakis(dimethylamino)silane (Si[N(CH₃)₂]₄) gas, tris(dimethylamino)silane (Si[N(CH₃)₂]₃H) gas, bis(diethylamino)silane (Si[N(C₂H₅)₂]₂H₂) gas, bis(tert-butylamino)silane (SiH₂[NH(C₄H₉)]₂) gas, and (diisopropylamino)silane (SiH₃[N(C₃H₇)₂]) gas, etc. Further, for example, gases containing Si as the first element and hydrogen (H) groups may be used as the first precursor gas. Examples of the gas containing Si and H groups may include monosilane (SiH₄), disilane (Si₂H₆), and the like. One or more of these gases may be used as the first precursor gas.

In addition to these, for example, gases containing Si and alkyl groups as organic ligands, i.e., alkylsilane-based gases, may also be used as the first precursor gas. The alkyl groups may be either linear or branched. Examples of the alkyl groups may include methyl, ethyl, n-propyl, n-butyl, isopropyl, isobutyl, sec-butyl, and tert-butyl groups, etc.

Further, for example, one or more of tungsten (W), titanium (Ti), molybdenum (Mo), tantalum (Ta), cobalt (Co), yttrium (Y), ruthenium (Ru), hafnium (Hf), zirconium (Zr), aluminum (Al), boron (B), gallium (Ga), indium (In), phosphorus (P), carbon (C), etc., may be used as the first element.

For example, gases containing the first element and halogen elements may be used as the first precursor gas. Examples of these gases may include hexachlorotungsten (WCl₆), hexafluorotungsten (WF₆), titanium tetrachloride (TiCl₄), titanium tetrafluoride (TiF₄), molybdenum pentachloride (MoCls), molybdenum pentafluoride (MoF₅), molybdenum dioxide dichloride (MoO₂Cl₂), molybdenum oxytetrachloride (MoOCl₄), tantalum pentachloride (TaCl₅), tantalum pentafluoride (TaFs), cobalt difluoride (CoF₂), cobalt dichloride (CoCl₂), yttrium trifluoride (YF₃), yttrium trichloride (YCl₃), ruthenium trichloride (RuCl₃), ruthenium trifluoride (RuF₃), hafnium tetrachloride (HfCl₄), hafnium tetrafluoride (HfF₄), zirconium tetrachloride (ZrCl₄), zirconium tetrafluoride (ZrF₄), aluminum trichloride (AlCl₃), aluminum trifluoride (AlF₃), and others. Further, for example, boron trifluoride (BF₃), boron trichloride (BCl₃), gallium trifluoride (GaF₃), gallium trichloride (GaCl₃), indium trifluoride (InF₃), indium trichloride (InCl₃), phosphorus trifluoride (PF₃), phosphorus pentafluoride (PF₅), phosphorus trichloride (PCl₃), phosphorus pentachloride (PCl₅), carbon tetrafluoride (CF₄), carbon tetrachloride (CCl₄), trifluoromethane (CHF₃), fluoromethane (CH₃F), trichloromethane (CHCl₃), chloromethane (CH₃Cl), and others may be used as the first precursor gas. For example, gases containing the first element and Br groups, or gases containing the first element and I groups may be used as the first precursor gas.

In addition to these, for example, gases containing the first element and organic ligands, or gases containing the first element and hydrogen groups may be used as the first precursor gas. Examples of the organic ligands may include alkyl, cycloalkyl, alkoxide, phenyl, cyclopentadienyl groups, etc. For example, hexadimethylaminoditungsten (W₂[N(CH₃)₂]₆), bistertiarybutylimide bisdimethylamide tungsten ((t-C₄H₉NH)₂W=(Nt-C₄H₉)₂), tetrakisethylmethylaminotitanium (Ti[N(C₂H₅)(CH₃)]₄), bisethylcyclopentadienylruthenium (Ru(CH₂CH₃)Cp)₂), biscyclopentadienylruthenium (Ru(Cp)₂), tetrakisethylmethylaminohafnium (Hf[N(CH₃)(CH₂CH₃)]₄), tetrakisdiethylaminohafnium (Hf[N(CH₂CH₃)₂]₄), tetrakisdimethylaminohafnium (Hf[N(CH₃)₂]₄), trisdimethylaminocyclopentadienylhafnium ((Cp)Hf[N(CH₃)₂]₃), tetrakiscyclopentadienylmethylaminozirconium (Zr[N(CH₃)Cp]₄), tetrakisdiethylaminozirconium (Zr[N(CH₂CH₃)₂]₄), tetrakisdimethylaminozirconium (Zr[N(CH₃)₂]₄), trisdimethylaminocyclopentadienylzirconium ((Cp)Zr[N(CH₃)₂]₃), trimethylaluminum (Al(CH₃)₃), boron (BH₃), trimethyl gallium (Ga(CH₃)₃), trimethylindium (In(CH₃)₃), phosphine (PH₃), methane (CH₄), and others may be used as the first precursor gas.

As for the inert gas, for example, nitrogen (N₂) gas or noble gases such as argon (Ar) gas, helium (He) gas, neon (Ne) gas, xenon (Xe) gas, etc., may be used. One or more of these gases may be used as the inert gas. This applies similarly to each step to be described later.

After the first precursor gas is adsorbed on the surface of the wafer 200 (the upper surface and inner surface of the recess), the valve 243a is closed to stop the supply of the first precursor gas into the process chamber 201. Then, the interior of the process chamber 201 is vacuum-exhausted, removing a residual gaseous substance and others from the process chamber 201. At this time, the valves 243f to 243h are opened to supply an inert gas into the process chamber 201 through the nozzles 249a to 249c. The inert gas supplied from the nozzles 249a to 249c acts as a purge gas, thereby purging the space where the wafer 200 exists, i.e. the interior of the process chamber 201 (purging).

### [Step B]

After step A is completed, the first adsorption inhibitor gas is supplied to the wafer 200 in the process chamber 201, i.e., the wafer 200 after the first precursor gas is adsorbed on the inner surface of the recess.

Specifically, the valve 243d is opened to flow the first adsorption inhibitor gas into the gas supply pipe 232d. The first adsorption inhibitor gas is regulated in flow rate by the MFC 241d, is supplied into the process chamber 201 through the nozzle 249a, and is exhausted from the exhaust port 231a. At this time, the first adsorption inhibitor gas is supplied to the wafer 200 (first adsorption inhibitor gas supply). At this time, the valves 243f to 243h may be opened to supply an inert gas into the process chamber 201 through the respective nozzles 249a to 249c.

A processing condition when supplying the first adsorption inhibitor gas in this step is exemplified as follows:
Processing temperature: 400 to 900 degrees C, particularly 500 to 800 degrees C;
Processing pressure: 1 to 2,666 Pa, particularly 10 to 1,333 Pa;
First adsorption inhibitor gas supply flow rate: 0.001 to 2 slm, particularly 0.01 to 1 slm;
First adsorption inhibitor gas supply time: 1 to 40 seconds, particularly 2 to 20 seconds; and
Inert gas supply flow rate (per gas supply pipe): 0 to 10 slm.
The other processing conditions may be similar to those when supplying the first precursor gas in step A.

It is desirable that the first adsorption inhibitor gas supply time is shorter than the first precursor gas supply time in step A. Further, it is desirable that the processing pressure (total pressure) in this step is lower than the processing pressure in step A. Further, it is desirable that the first adsorption inhibitor gas supply flow rate is smaller than the first precursor gas supply flow rate in step A. Further, it is desirable that the inert gas supply flow rate in this step is greater than the inert gas supply flow rate in step A.

Furthermore, it is desirable that a partial pressure of the first adsorption inhibitor gas is lower than a partial pressure of the first precursor gas in step A. It is desirable that a mole fraction of the first adsorption inhibitor gas is smaller than a mole fraction of the first precursor gas in step A.

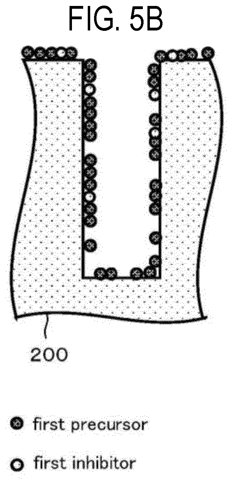

By supplying the first adsorption inhibitor gas to the wafer 200 under the above-described processing condition, the first adsorption inhibitor gas may be adsorbed on adsorption sites present on the surface of the wafer 200 *(see* FIG. 5B). Specifically, this allows the first adsorption inhibitor gas to be adsorbed discontinuously on at least a portion of the upper surface and inner surface of the recess *(see* FIG. 5B). Specifically, this allows the first adsorption inhibitor gas to be adsorbed preferentially to the opening side rather than the deep side *(see* FIG. 5B). In addition, the upper surface and inner surface of the recess, on which the first precursor gas is adsorbed, are in a state where a predetermined functional group of the first adsorption inhibitor gas is exposed.

By performing steps A and B under the above-described processing conditions, an exposure amount of the first adsorption inhibitor gas may be made smaller than an exposure amount of the first precursor gas. In the present disclosure, the term "exposure amount of a gas" refers to a value obtained by integrating a partial pressure of the gas over time. When the partial pressure of the gas is considered constant, the exposure amount may be obtained as a product of the partial pressure of the gas and a gas supply time.

By performing steps A and B under the above-described processing conditions, an amount of the first adsorption inhibitor gas adsorbed on the deep side may be made less than an amount of the first precursor gas adsorbed on the deep side *(see* FIG. 5B).

As for the first adsorption inhibitor gas, halogen-containing gases that contain at least one selected from the group of Cl, F, Br, and I may be used. The halogen-containing gases contain at least one selected from halogen groups of Cl, F, Br, I groups, etc., as functional groups. For example, halogen elemental gases such as fluorine (F₂) gas, chlorine (Cl₂) gas, bromine (Br₂) gas, iodine (I₂) gas, etc., interhalogen compound gases such as chlorine fluoride (ClF₃) gas, bromine chloride (BrCl) gas, iodine chloride (ICl) gas, iodine pentafluoride (IF₅) gas, bromine fluoride (BrF₃) gas, iodine bromide (IBr) gas, etc., hydrogen halide compound gases such as hydrogen chloride (HCl) gas, hydrogen fluoride (HF) gas, hydrogen bromide (HBr) gas, hydrogen iodide (HI) gas, etc., or a combination of these gases may be used as the first adsorption inhibitor gas.

Further, gases containing organic compounds may be used as the first adsorption inhibitor gas. The gases containing organic compounds may include gases containing at least one selected from the group consisting of ether compounds, ketone compounds, amine compounds, organic hydrazine compounds, and compounds with a cyclic structure in a molecular structure. The gases containing ether compounds may include gases containing at least one selected from the group of dimethyl ether, diethyl ether, methyl ethyl ether, propyl ether, isopropyl ether, furan, tetrahydrofuran, pyran, tetrahydropyran, and others. The gases containing ketone compounds may include gases containing at least one selected from the group of dimethyl ketone, diethyl ketone, methyl ethyl ketone, methyl propyl ketone, and others. The gases containing amine compounds may include gases containing at least one selected from the group of methylamine compounds such as monomethylamine, dimethylamine, trimethylamine, etc., ethylamine compounds such as monoethylamine, diethylamine, triethylamine, etc., and methylethylamine compounds such as dimethylethylamine, methyldiethylamine, etc. The gases containing organic hydrazine compounds may include gases containing at least one selected from the group of methylhydrazine-based gases such as monomethylhydrazine, dimethylhydrazine, trimethylhydrazine, etc. The gases containing compounds with a cyclic structure may include gases with a cyclic structure containing at least one selected from the group of cycloalkyl groups, a benzene ring structure, and carbon in the molecular structure such as methoxycyclopentane, anisole, trimethylene oxide, etc. One or more of these gases may be used as the first adsorption inhibitor gas. Alkyl group-containing gases that contain alkyl groups may also be used. A methane (CH₄) gas, ethane (C₂H₆) gas, propane (C₃H₈) gas, and others may also be used as the first adsorption inhibitor gas.

It is desirable to use gases that do not contain the first element as the first adsorption inhibitor gas.

It is desirable that a molecular radius of the first adsorption inhibitor gas used in this step is smaller than a molecular radius of the first precursor gas used in step A.

After the first adsorption inhibitor gas is adsorbed on the surface of the wafer 200 (the upper surface and inner surface of the recess), the valve 243d is closed to stop the supply of the first adsorption inhibitor gas into the process chamber 201. Then, the interior of the process chamber 201 is vacuum-exhausted, removing a residual gaseous substance and others from the process chamber 201. At this time, the valves 243f to 243h are opened to supply an inert gas into the process chamber 201 through the nozzles 249a to 249c. The inert gas supplied from the nozzles 249a to 249c acts as a purge gas, thereby purging the space where the wafer 200 exists, i.e. the interior of the process chamber 201 (purging).

### [Step C]

After step B is completed, the second precursor gas containing the second element different from the first element is supplied to the wafer 200 in the process chamber 201, i.e., the wafer 200 after the first precursor gas and the first adsorption inhibitor gas are adsorbed on the upper surface and inner surface of the recess.

Specifically, the valve 243b is opened to flow the second precursor gas into the gas supply pipe 232b. The second precursor gas is regulated in flow rate by the MFC 241b, is supplied into the process chamber 201 through the nozzle 249b, and is exhausted from the exhaust port 231a. At this time, the second precursor gas is supplied to the wafer 200 (second precursor gas supply). At this time, the valves 243f to 243h may be opened to supply an inert gas into the process chamber 201 through the respective nozzles 249a to 249c.

A processing condition when supplying the second precursor gas in this step is exemplified as follows:
Processing temperature: 400 to 900 degrees C, particularly 500 to 800 degrees C;
Processing pressure: 1 to 5,000 Pa, particularly 10 to 1,333 Pa;
Second precursor gas supply flow rate: 0.01 to 2 slm, particularly 0.1 to 1 slm;
Second precursor gas supply time: 5 to 50 seconds, particularly 6 to 30 seconds; and
Inert gas supply flow rate (per gas supply pipe): 0 to 10 slm.

The other processing conditions may be similar to those when supplying the first precursor gas in step A.

Herein, it is desirable that the second precursor gas supply time is longer than the first adsorption inhibitor gas supply time in step B. It is desirable that the processing pressure in this step is higher than the processing pressure in step B. It is desirable that the second precursor gas supply flow rate is greater than the first adsorption inhibitor gas supply flow rate in step B. Further, it is desirable that the inert gas supply flow rate in this step is smaller than the inert gas supply flow rate in step B.

Furthermore, it is desirable that a partial pressure of the second precursor gas is higher than the partial pressure of the first adsorption inhibitor gas in step B. It is desirable that a mole fraction of the second precursor gas is greater than the mole fraction of the first adsorption inhibitor gas in step B.

By performing steps B and C under the above-described processing conditions, an exposure amount of the second precursor gas may be made greater than the exposure amount of the first adsorption inhibitor gas.

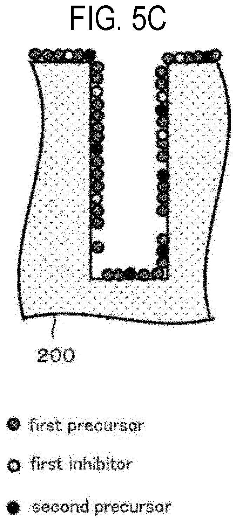

By supplying the second precursor gas to the wafer 200 under the above-described processing condition, the second precursor gas may be adsorbed on a location on the surface of the wafer 200 where the first precursor gas and the first adsorption inhibitor gas are not adsorbed, i.e., the remaining adsorption sites on the surface of the wafer 200 *(see* FIG. 5C).

Herein, the first precursor gas and the first adsorption inhibitor gas are gases that inhibit the adsorption of the second precursor gas onto the wafer 200. Specifically, functional groups contained in the first precursor gas and the first adsorption inhibitor gas, which are formed (exposed) on the upper surface and inner surface of the recess, inhibit the adsorption of the second precursor gas on the wafer 200 (the upper surface and inner surface of the recess). Consequently, as illustrated in FIG. 5C, the second precursor gas is not adsorbed onto the first precursor gas and the first adsorption inhibitor gas on the surface of the wafer 200. Therefore, by regulating the processing condition in step A or step B to control the amount of the first precursor gas or the first adsorption inhibitor gas adsorbed on the wafer 200, an amount of the second source precursor gas adsorbed on the wafer 200 may be controlled. Herein, in the present disclosure, "the second precursor gas not being adsorbed on the first precursor gas and the first adsorption inhibitor gas" includes a case where none of the second precursor gas is adsorbed on the first precursor gas and the first adsorption inhibitor, as well as a case where a very small amount of the second precursor gas is adsorbed on the first precursor gas and/or the first adsorption inhibitor gas. For example, this includes a case where the second precursor gas is adsorbed on about 1% or desirably less than 1% of the first precursor gas and/or the first adsorption inhibitor gas on the wafer 200.

By performing steps A to C, the first precursor gas, the first adsorption inhibitor gas, and the second precursor gas may be adsorbed on the adsorption sites provided on the surface of the wafer 200, thereby forming a layer (hereinafter sometimes referred to as "first layer") containing the first and second elements. In other words, a first layer to which the second element is added (doped) may be formed.

By performing steps B and C under the above-described processing conditions, an amount of the second precursor gas adsorbed to the deep side may be made greater than an amount of the first adsorption inhibitor gas adsorbed to the deep side.

Herein, among the elements exemplified as the first element, any element, which is not included in the first precursor gas as the first element, i.e., different from the first element, may be used as the second element. Further, the second precursor gas may include gases containing the second element among the gases exemplified as the first precursor gas. Examples of the gases containing the second element may include gases containing the second element and halogen elements, gases containing the second element and organic ligands, and gases containing the second element and H groups.

If hydrophilic functional groups are formed on the wafer 200 in steps A and B, it is desirable to use gases containing hydrophilic functional groups in the molecular structure (hydrophilic gases) as the second precursor gas in step C. Herein, the hydrophilic functional groups are functional groups that are likely to generate partial charges due to an uneven distribution of electrons in the molecular structure. Further, if hydrophobic functional groups are formed on the wafer 200 in steps A and B, it is desirable to use gases containing hydrophobic functional groups (hydrophobic gases) as the second precursor gas in step C. Herein, the hydrophobic functional groups area functional groups that are unlikely to generate partial charges.

After the second precursor gas is adsorbed on the surface of the wafer 200 (the inner surface of the recess), the valve 243b is closed to stop the supply of the second precursor gas into the process chamber 201. Then, the interior of the process chamber 201 is vacuum-exhausted, removing a residual gaseous substance and others from the process chamber 201. At this time, the valves 243f to 243h are opened to supply an inert gas into the process chamber 201 through the nozzles 249a to 249c. The inert gas supplied from the nozzles 249a to 249c acts as a purge gas, thereby purging the space where the wafer 200 exists, i.e. the interior of the process chamber 201 (purging).

### [Step D]

After step C is completed, the reactant gas is supplied to the wafer 200 in the process chamber 201, i.e., the wafer 200 after the first precursor gas, the first adsorption inhibitor gas, and the second precursor gas are adsorbed on the upper surface and inner surface of the recess.

Specifically, the valve 243c is opened to flow the reactant gas into the gas supply pipe 232c. The reactant gas is regulated in flow rate by the MFC 241c, is supplied into the process chamber 201 through the nozzle 249c, and is exhausted from the exhaust port 231a. At this time, the reactant gas is supplied to the wafer 200 (reactant gas supply). At this time, the valves 243f to 243h may be opened to supply an inert gas into the process chamber 201 through the respective nozzles 249a to 249c.

A processing condition when supplying the reactant gas in this step is exemplified as follows:
Processing pressure: 1 to 4,000 Pa, particularly 10 to 1,000 Pa;
Reactant gas supply flow rate: 0.1 to 10 slm, particularly 1 to 5 slm; and
Reactant gas supply time: and 1 to 120 seconds, particularly 10 to 60 seconds.

The other processing conditions may be similar to those when supplying the first precursor gas in step A.

By supplying the reactant gas to the wafer 200 under the above-described processing condition, at least a portion of the first layer formed on the inner surface of the recess reacts with the reactant gas, thus being modified. As a result, a modified layer of the first layer (hereinafter sometimes referred to as "second layer") is formed on the inner surface of the recess. When forming the second layer, it is desirable that the reactant gas removes (desorbs) at least some of the functional groups formed on the wafer 200 in step B from the first layer through a chemical reaction. The removed functional groups are discharged from the interior of the process chamber 201. Thus, the second layer is a layer with fewer impurities compared to the first layer formed in step C.

As for the reactant gas, for example, gases including a reducing gas, an oxidizing gas, a nitriding gas, a sulfurizing gas, a selenizing gas, a tellurizing gas, and others may be used. One or more of these gases may be used as the reactant gas.

Examples of the reducing gas may include a hydrogen (H₂) gas, deuterium (D₂) gas, borane (BH₃) gas, diborane (B₂H₆) gas, carbon monoxide (CO) gas, ammonia (NH₃) gas, monosilane (SiH₄) gas, disilane (Si₂H₆) gas, trisilane (Si₃H₈) gas, monogerman (GeH₄) gas, digerman (Ge₂H₆) and others, and one or more of these gases may be used. Further, for example, an oxidizing gas containing oxygen (O) may be used as the reactant gas. Examples of the oxidizing gas may include oxygen (O₂), ozone (O₃), water vapor (H₂O), a mixed gas of H₂ and O₂, hydrogen peroxide (H₂O₂), nitrous oxide (N₂O), and others, and one or more of these gases may be used. Examples of the nitriding gas may include hydronitrogen-based gases such as ammonia (NH₃) gas, diazen (N₂H₂) gas, hydrazine (N₂H₄) gas, N₃H₈ gas, and others, and one or more of these gases may be used. Examples of the sulfurizing gas may include sulfane (H₂S), disulfane (H₂S₂), diammonium sulfide ((NH₄)₂S), dimethyl sulfide ((CH₃)₂S), and one or more of these gases may be used. Examples of the selenizing gas may include gases containing hydrogen selenide (H₂Se), diselane (H₂Se₂), dimethylselenium ((CH3) 2Se), and others, and one or more of these gases may be used. Examples of the tellurizing gas may include gases containing hydrogen telluride (H₂Te), ditelane (H₂Te₂), dimethyltelane ((CH₃)₂Te), and others, and one or more of these may be used.

After modifying the first layer formed on the surface of the wafer 200 (the inner surface of the recess) into the second layer, the valve 243c is closed to stop the supply of the reactant gas into the process chamber 201. Then, the interior of the process chamber 201 is vacuum-exhausted, removing a residual gaseous substance and others from the process chamber 201. At this time, the valves 243f to 243h are opened to supply an inert gas into the process chamber 201 through the nozzles 249a to 249c. The inert gas supplied from the nozzles 249a to 249c acts as a purge gas, thereby purging the space where the wafer 200 exists, i.e. the interior of the process chamber 201 (purging).

### [Performing Predetermined Number of Times]

By performing the first cycle of performing the above-described steps A to D in this order non-simultaneously, i.e., without synchronization, n times (where n is an integer greater than or equal to 1), it is possible to form a film with a desired composition on the surface of the wafer 200 (the inner surface of the recess). For example, if a silane-based gas is used as the first precursor gas and a nitriding gas is used as the reactant gas, a silicon nitride film (SiN film) is formed on the surface of the wafer 200. It is desirable to make a thickness of the second layer formed per cycle thinner than a desired film thickness and to repeat the above-described cycle multiple times until and a thickness of a film formed by stacking the second layers reaches the desired film thickness. This allows for further uniformization of the thickness of the film formed in the recess.

For example, if the reactant gas is a reducing gas, a film mainly composed of the first and second elements may be formed on the wafer 200. For example, if one of the oxidizing gas, nitriding gas, sulfurizing gas, selenizing gas, and tellurizing gas is used as the reactant gas, it is possible to form an oxide film containing the first and second elements, a nitride film containing the first and second elements, a sulfide film containing the first and second elements, a selenide film containing the first and second elements, and a telluride film containing the first and second elements on the wafer 200.

### (After-Purge and Atmospheric Pressure Recovery)

After the film-forming process is completed, an inert gas serving as a purge gas is supplied into the process chamber 201 from the respective nozzles 249a to 249c, and is exhausted from the exhaust port 231a. Thus, the interior of the process chamber 201 is purged, and any gases and reaction by-products remaining in the process chamber 201 are removed from the interior of the process chamber 201 (after-purge). Thereafter, the atmosphere in the process chamber 201 is replaced by the inert gas (inert gas replacement), and the internal pressure of the process chamber 201 is restored to normal pressure (atmospheric pressure recovery).

### (Boat Unloading and Wafer Discharge)

Thereafter, the seal cap 219 is moved down by the boat elevator 115 to open the lower end of the manifold 209. Then, the processed wafer 200 is unloaded (boat unloading) from the lower end of the manifold 209 to an outside of the reaction tube 203 while being supported by the boat 217. After the boat unloading, the shutter 219s is moved, and the opening at the lower end of the manifold 209 is sealed by the shutter 219s via the O-ring 220c (shutter-close). The processed wafer 200 is unloaded to the outside of the reaction tube 203, and thereafter, is taken out from the boat 217 (wafer discharge).

### (3) Effects of Present Embodiments

According to the present embodiments, one or more effects described below are acquired.
(a) After supplying the first precursor gas and the first adsorption inhibitor gas to the wafer 200 to form the functional groups that inhibit the adsorption of the second precursor gas in steps A and B, the second precursor gas is supplied to the wafer 200 to form the layer containing the first and second elements in at least a part of step C. This reduces a difference in an adsorption amount of the second precursor gas between the opening side and the deep side, i.e., reduces the variation in a concentration of the second element in the film within the recess. As a result, it is possible to improve the uniformity of the film formed on the surface of the wafer 200. This is described below.

The gases supplied to the wafer 200 with the recess tend to reach (adsorb on) the opening side more easily and to reach the deep side with more difficulty. Therefore, in step C as well, the second precursor gas tends to be adsorbed more on the opening side than to the deep side. As a result, the uniformity of the film formed on the surface of the wafer 200 may deteriorate.

In the present embodiments, after supplying the first precursor gas and the first adsorption inhibitor gas to the wafer 200 to form the functional groups that inhibit the adsorption of the second precursor gas on the wafer 200 in steps A and B, the second precursor gas is supplied to the wafer 200 to form the layer containing the first and second elements in step C. In other words, before starting step C, the functional groups that inhibit the adsorption of the second precursor gas are formed more on the opening side than on the deep side. Therefore, this allows the adsorption of the second precursor gas to be inhibited on the opening side while making it less likely to be inhibited on the deep side. This reduces the difference in the adsorption amount of the second precursor gas between the opening side and the deep side. As a result, it is possible to improve the uniformity of the film formed on the surface of the wafer.

(b) It is desirable that the amount of the second precursor gas adsorbed to the deep side is greater than the amount of the first adsorption inhibitor gas. This allows the adsorption of the second precursor gas to be inhibited on the opening side while making it less likely to be inhibited on the deep side. This may further reduce the difference in the adsorption amount of the second precursor gas between the opening side and the deep side.

(c) It is desirable that the exposure amount of the second precursor gas is greater than the exposure amount of the first adsorption inhibitor gas. This allows the amount of the second precursor gas adsorbed on the deep side to be greater than that of the first adsorption inhibitor gas. This may further reduce the difference in the adsorption amount of the second precursor gas between the opening side and the deep side.

In addition, it is desirable to establish at least one selected from the group of 1 to 6 listed below (this enables the exposure amount of the second precursor gas to be greater than the exposure amount of the first adsorption inhibitor gas):
1. The second precursor gas supply time in step C is made longer than the first adsorption inhibitor gas supply time in step B;
2. The processing pressure in step C is made higher than the processing pressure in step B;
3. The second precursor gas supply flow rate in step C is made greater than the first adsorption inhibitor gas supply flow rate in step B;
4. The inert gas supply flow rate in step C is made smaller than the inert gas supply flow rate in step B;
5. The partial pressure of the second precursor gas in the process chamber 201 in step C is made higher than the partial pressure of the first adsorption inhibitor gas in the process chamber 201 in step B; and
6. The mole fraction of the second precursor gas among the gases in the process chamber 201 in step C is made greater than the mole fraction of the first adsorption inhibitor gas in step B.

(d) It is desirable that the amount of the first adsorption inhibitor gas adsorbed on the deep side is less than the amount of the first precursor gas. This allows the adsorption of the second precursor gas to be inhibited on the opening side while making it less likely to be inhibited on the deep side. This may further reduce the difference in the adsorption amount of the second precursor gas between the opening side and the deep side.

(e) Making the exposed amount of the first adsorption inhibitor gas smaller than the exposed amount of the first precursor gas is desirable because it enables the amount of the first adsorption inhibitor gas adsorbed on the deep side to be smaller than the amount of the first precursor gas adsorbed on the deep side. In this case, it is easier to inhibit the adsorption of the second precursor gas on the opening side while making it less likely to be inhibited on the deep side. As a result, the difference in the adsorption amount of the second precursor gas between the opening side and the deep side may be further reduced.

In addition, it is desirable to establish at least one selected from the group of 7 to 12 listed below (this enables the exposure amount of the first adsorption inhibitor gas to be smaller than the exposure amount of the first precursor gas):

7. The first adsorption inhibitor gas supply time in step B is made shorter than the first precursor gas supply time in step A;

8. The processing pressure in step B is made lower than the processing pressure in step A;

9. The first adsorption inhibitor gas supply flow rate in step B is made smaller than the first precursor gas supply flow rate in step A;

10. The inert gas supply flow rate in step B is made greater than the inert gas supply flow rate in step A;

11. The partial pressure of the first adsorption inhibitor gas in the process chamber 201 in step B is made lower than the partial pressure of the first precursor gas in the process chamber 201 in step A; and

12. The mole fraction of the first adsorption inhibitor gas among the gases in the process chamber 201 in step B is made smaller than the mole fraction of the first precursor gas among the gases in the process chamber 201 in step A.

(f) As described above, it is desirable that the adsorption amount of the first adsorption inhibitor gas on the opening side is greater than that on the deep side in step B. From this, it is desirable that the first adsorption inhibitor gas does not contain the first element. This allows a uniform layer of the first element to be formed throughout the recess.

(g) It is desirable that the reactant gas removes the functional groups (functional groups derived from the first adsorption inhibitor gas) formed on the wafer 200 in step B through a chemical reaction. This may prevent deterioration of film properties caused by the introduction of elements derived from the first adsorption inhibitor gas into the film.

(h) When the number of the second element is smaller than the number of the first element in the layer formed by the above-described cycle, the variation in the concentration of the second element in the film within the recess, which is caused by the difference in the adsorption amount of the second precursor gas within the recess, tends to increase. Even in this case, the technique of the present disclosure may reliably reduce the variation in the concentration of the second element in the film within the recess. This may ensure that the uniformity of the film formed on the surface of the wafer 200 is reliably improved.

(i) By controlling the amount of the second precursor gas adsorbed on the wafer 200 with the processing condition in step A, the concentration of the second element in the film or layer may be controlled. Specifically, by regulating the processing condition in step A such as controlling the amount of the first precursor gas supplied to the wafer 200, the amount of the second precursor gas adsorbed on the wafer 200 may be controlled, thereby controlling the concentration of the second element in the film or layer.

(i) It is desirable that the molecular radius of the first adsorption inhibitor gas is smaller than the molecular radius of the first precursor gas. This reduces the likelihood that the functional groups formed on the wafer 200 in step A inhibit the adsorption of the first adsorption inhibitor gas to the wafer 200. Accordingly, it is possible to further reduce the variation in the concentration of the second element in the film within the recess, ensuring that the uniformity of the film formed on the surface of the wafer 200 is reliably improved.

(k) If hydrophilic functional groups are formed on the wafer 200 in steps A and B, it is desirable that the second precursor gas supplied in step C is a hydrophilic gas. For example, if a chlorosilane-based gas is supplied to the wafer 200 in step A and a Cl-containing gas is supplied to the wafer 200 in step B, hydrophilic Cl groups (functional groups) are formed on the wafer 200. In such a case, it is desirable to supply gases containing the second element and halogen elements as the hydrophilic second precursor gas to the wafer 200 in step C. Further, if hydrophobic functional groups are formed on the wafer 200 in steps A and B, it is desirable that the second precursor gas supplied in step C is a hydrophobic gas. For example, if aminosilane-based gases are supplied to the wafer 200 in step A and gases containing alkyl groups are supplied to the wafer 200 in step B, hydrophobic alkyl groups (functional groups) are formed on the wafer 200. In such a case, it is desirable to supply gases containing the second element and organic ligands as the hydrophobic second precursor gas to the wafer 200 in step C. In such a case, the functional groups formed on the wafer 200 in steps A and B facilitate the inhibition of the adsorption of the second precursor gas on the wafer 200. Accordingly, it is possible to reliably reduce the variation in the concentration of the second element in the film within the recess, ensuring that the uniformity of the film formed on the surface of the wafer 200 is reliably improved.

In addition, a reactivity of a nitriding gas with a bond between a certain atom and a halogen group tends to be higher than a reactivity of the nitriding gas with a bond between a certain atom and an organic ligand. Therefore, for example, if the reactant gas is a nitriding gas and a layer or film containing the first element, the second element, and N is formed, it is desirable that the first precursor gas, the first adsorption inhibitor gas, and the first precursor gas contain a halogen group in the molecular structure. This may reduce the likelihood of incorporating impurities derived from organic ligands into the second layer or film.

(l) The same effects as described above may be obtained even when predetermined substances (gaseous substances and liquid substances) are arbitrarily selected and used from among the various precursor gases, adsorption inhibitor gases, reactant gases, and inert gases described above.

### (4) Modifications

The process sequence in the present embodiments may be modified as in the following modifications. These modifications may be combined arbitrarily. Unless otherwise specified, a processing procedure and processing condition for each step in each modification may be the same as the processing procedure and processing condition for each step in the above-described process sequence.

### (Modification 1)

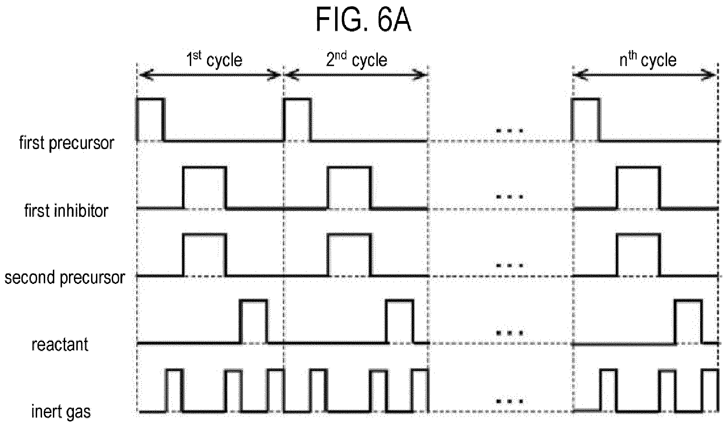

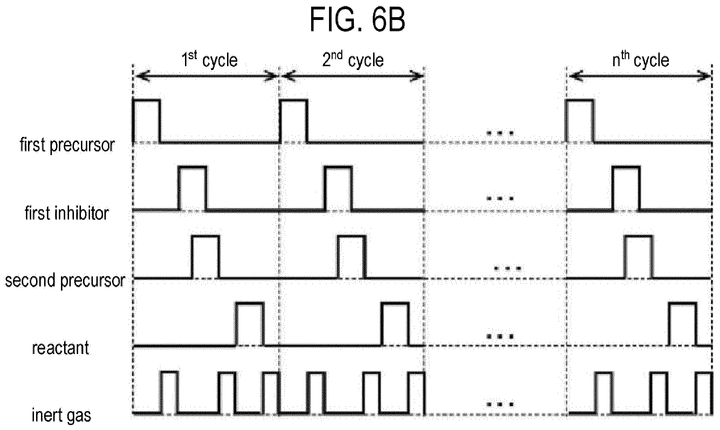

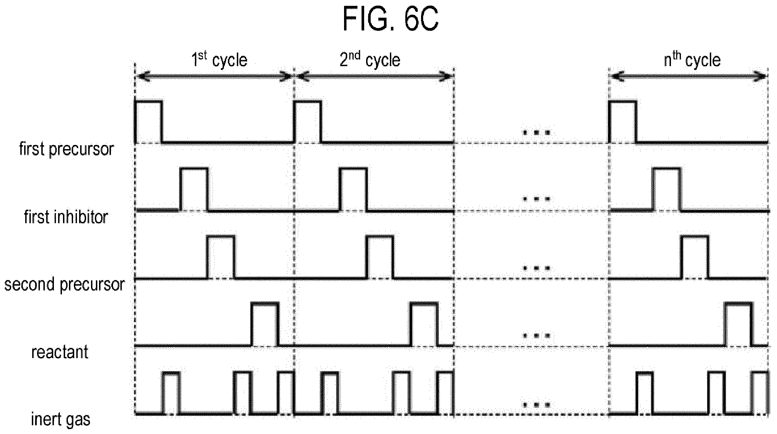

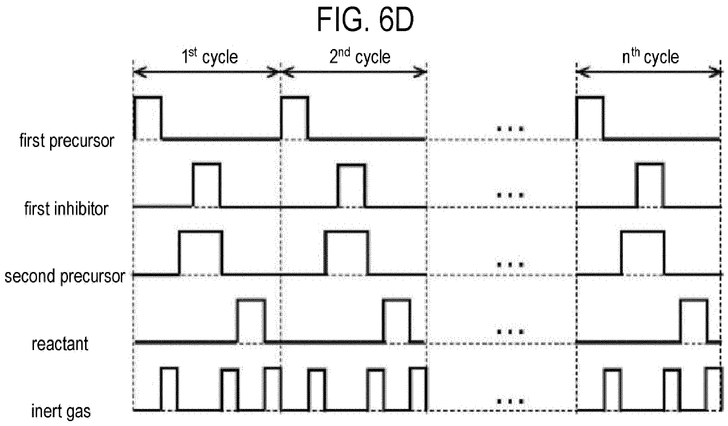

As in a process sequence illustrated in FIG. 6A and below, implementation periods for steps B and C may overlap, and after performing step A, steps B and C may be performed simultaneously, followed by step D. Further, as in a process sequence illustrated in FIG. 6B and below, the implementation periods for steps B and C may partially overlap, and steps A, B, C and D may be performed in this order. Further, as in a process sequence illustrated in FIG. 6C and below, the implementation periods for steps B and C may be consecutive, and steps A, B, C and D may be performed in this order. Further, as in a process sequence illustrated in FIG. 6D and below, the entire implementation period for step B and a part of the implementation period for step C may overlap, and steps A, C, B and D may be performed in this order.(First precursor gas → First adsorption inhibitor gas + Second precursor gas →Reactant gas) × n (First precursor gas → First adsorption inhibitor gas → First adsorption inhibitor gas + Second precursor gas → Second precursor gas → Reactant gas) × n (First precursor gas → First adsorption inhibitor gas | Second precursor gas → Reactant gas) × n (First precursor gas → Second precursor gas → First adsorption inhibitor gas + Second precursor gas → Reactant gas) × n

In the present disclosure, "|" in the "First adsorption inhibitor gas | Second precursor gas" indicates that purging to purge the interior of the process chamber 201 is not performed.

It is desirable that gases that do not react with each other are used as the first adsorption inhibitor gas and the second precursor gas.

The same effects as the above-described embodiments are obtained in this modification as well. In this modification, furthermore, it is possible to shorten the cycle time and improve the productivity of the film-forming process. In addition, in the process sequence illustrated in FIG. 6D and below, the second precursor gas is supplied to the wafer 200, on which the first precursor gas and the first adsorption inhibitor gas are adsorbed, just during a part of step C. Even in such a case, the same effects as the above-described embodiments are obtained. In other words, it is desirable to supply the second precursor gas to the wafer 200, on which the first precursor gas and the first adsorption inhibitor gas are adsorbed, during at least a part of step C.

### (Modification 2)

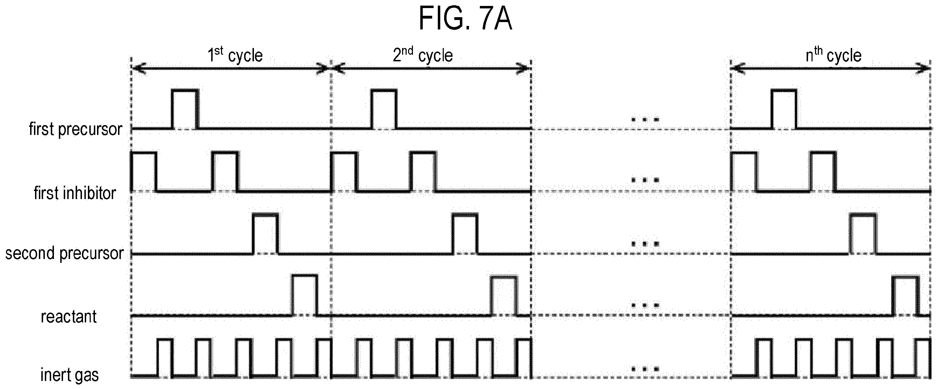

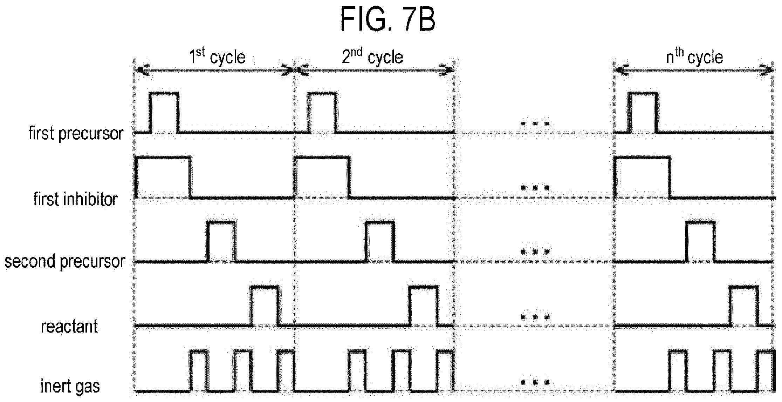

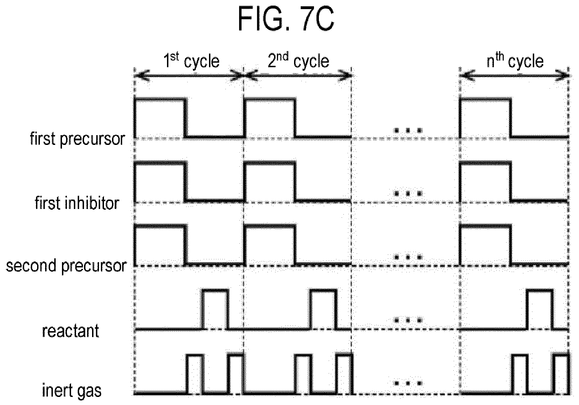

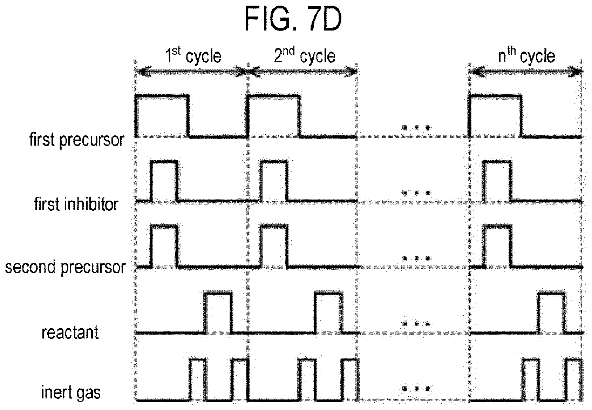

In at least a part of step A, the first precursor gas may be supplied to the wafer 200 on which the first adsorption inhibitor gas is adsorbed. Specifically, as in a process sequence illustrated in FIG. 7A and below, after performing the step of supplying the first adsorption inhibitor gas to the wafer 200, steps A, B, C, and D may be performed in this order. As in a process sequence illustrated in FIG. 7B and below, an entire implementation period for step A and a part of the implementation period for step B may overlap, and steps B, A, C and D may be performed in this order. As in a process sequence illustrated in FIG. 7C and below, the implementation periods for steps A, B and C may overlap, and steps A, B and C may be performed simultaneously, followed by step D. As in a process sequence illustrated in FIG. 7D and below, a part of the implementation period for step A and the entire implementation periods for steps B and C may overlap, and after initiating step A, steps B and C may be performed simultaneously, followed by step D.(First adsorption inhibitor gas → First precursor gas → First adsorption inhibitor gas → Second precursor gas → Reactant gas) × n (First adsorption inhibitor gas → First adsorption inhibitor gas + First precursor gas → First adsorption inhibitor gas → Second precursor gas → Reactant gas) × n (First precursor gas + First adsorption inhibitor gas + Second precursor gas → Reactant gas) × n (First precursor gas → First precursor gas + First adsorption inhibitor gas + Second precursor gas → First precursor gas → Reactant gas) × n

The same effects as the above-described embodiments are obtained in this modification as well. In this modification, furthermore, it is possible to reduce the difference in the adsorption amount of the first precursor gas between the opening side and the deep side. As a result, the uniformity of the film within the recess may be improved.

### (Modification 3)

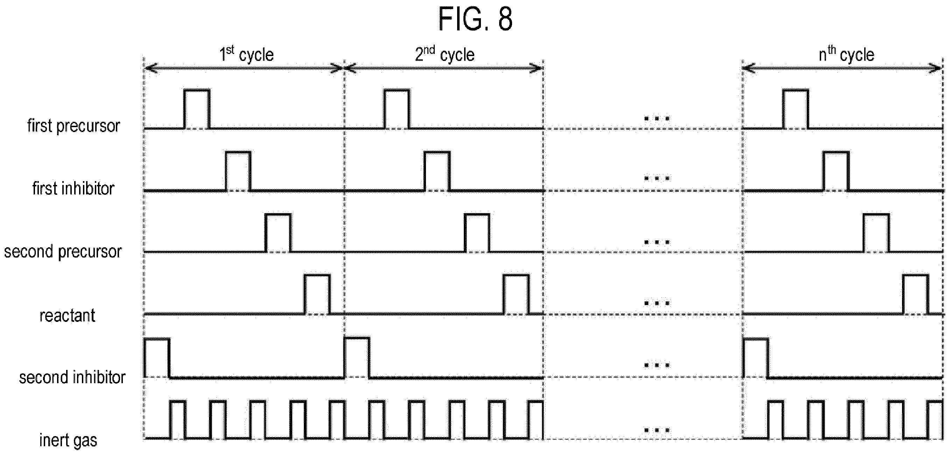

Step E of supplying the second adsorption inhibitor gas different from the first adsorption inhibitor gas to the wafer 200 may be further included, and in at least a part of step A, the first precursor gas may be supplied to the wafer 200 on which the second adsorption inhibitor gas is adsorbed. Specifically, as in a process sequence illustrated in FIG. 8 and below, the process may be performed in the order of steps E, A, B, C and D.(Second adsorption inhibitor gas → First precursor gas → First adsorption inhibitor gas → Second precursor gas → Reactant gas) × n

As for the second adsorption inhibitor gas, for example, one or more of the gases listed as examples of the first precursor gas may be used.

In step E, the second adsorption inhibitor gas supply system supplies the second adsorption inhibitor gas to the wafer 200 within the process chamber 201.

A processing condition when supplying the second adsorption inhibitor gas in this step is exemplified as follows:
Processing temperature: 350 to 700 degrees C, particularly 500 to 600 degrees C;
Processing pressure: 1 to 10,000 Pa, particularly 10 to 1,333 Pa;
Second adsorption inhibitor gas supply flow rate: 0.01 to 3 slm, particularly 0.1 to 1 slm;
Second adsorption inhibitor gas supply time: 10 to 120 seconds, particularly 20 to 60 seconds; and
Inert gas supply flow rate (per gas supply pipe): 0 to 10 slm.

By supplying the second adsorption inhibitor gas to the wafer 200 under the above-described processing condition, the second adsorption inhibitor gas may be adsorbed on the adsorption sites present on the surface of the wafer 200. By supplying the second adsorption inhibitor gas to the wafer 200 under the above-described processing condition, the adsorption of the first precursor gas on the wafer 200 in step A may be inhibited.

If hydrophilic functional groups are formed on the wafer 200 in steps A, B and E, it is desirable to use a hydrophilic gas as the second precursor gas in step C. Further, if hydrophobic functional groups are formed on the wafer 200 in steps A, B and E, it is desirable to use a hydrophobic gas as the second precursor gas in step C.

The same effects as the above-described embodiments are obtained in this modification as well. In this modification, furthermore, it is possible to reduce the difference in the adsorption amount of the first precursor gas between the opening side and the deep side. As a result, the uniformity of the film within the recess may be improved.

Furthermore, in Modification 3, if hydrophilic functional groups are formed on the wafer 200 in steps A, B and E, the supply of the hydrophilic second precursor gas enables the hydrophilic functional groups to more easily inhibit the adsorption of the second precursor gas onto the wafer 200. Similarly, if hydrophobic functional groups are formed on the wafer 200 in steps A, B and E, the supply of the hydrophobic second precursor gas enables the hydrophobic functional groups to more easily inhibit the adsorption of the second precursor gas onto the wafer 200. Accordingly, it is possible to reliably reduce the variation in the concentration of the second element in the film within the recess, ensuring that the uniformity of the film formed on the surface of the wafer 200 is reliably improved.

### (Modification 4)

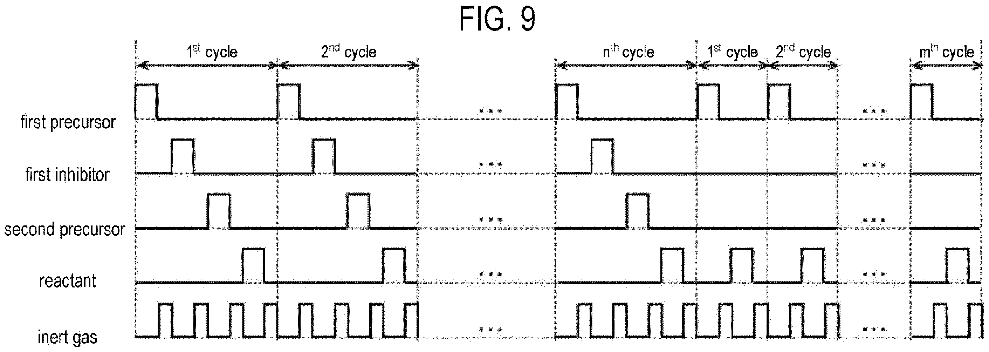

A second cycle that includes steps A and D and does not include step B may be further included. Specifically, as in a process sequence illustrated in FIG. 9 and below, after performing the first cycle, where steps A, B, C and D are performed in this order non-simultaneously, n times (where n is an integer greater than or equal to 1), the second cycle, including steps A and D but excluding step B, may be performed a predetermined number of times (m times, where m is an integer greater than or equal to 1).(First precursor gas → First adsorption inhibitor gas → Second precursor gas → Reactant gas) × n → (First precursor gas → Reactant gas) × m

The same effects as the above-described embodiments are obtained in this modification as well. In this modification, it is possible to form a film by stacking a layer containing both the first and second elements and a layer containing solely the first element. This allows for more precise control over the concentration of the second element in the film even when forming the film with a low concentration of the second element.

### <Other Embodiments of Present Disclosure>

The embodiments of the present disclosure are specifically described above. However, the present disclosure is not limited to the above-described embodiments, and may be changed in various ways without departing from the gist of the present disclosure.

For example, in the above-described embodiments, a case where a gas that does not contain the first element is used as the first adsorption inhibitor gas is described by way of example. However, the present disclosure is not limited to these embodiments. For example, the gas containing the first element may also be used as the first adsorption inhibitor gas. At least some of the effects of the above-described embodiments may be obtained in such a case as well.

For example, in the above-described embodiments, halogen groups as an example of hydrophilic functional groups and alkyl groups as an example of hydrophobic functional groups are formed on the wafer 200 in steps A and B. However, the present disclosure is not limited to these embodiments. For example, the hydrophilic functional groups formed on the wafer 200 in steps A and B may be alkoxide groups or amino groups, and the hydrophobic functional groups may be hydrogen groups, cycloalkyl groups, phenyl groups, cyclopentadienyl groups, and others. Gases containing alkoxide groups or amino groups, etc., as hydrophilic functional groups and gases containing cycloalkyl groups, phenyl groups, cyclopentadienyl groups and others as hydrophobic functional groups may be appropriately used as the first precursor gas and the first adsorption inhibitor gas. The same effects as the above-described embodiment are obtained in such a case as well.

For example, in the above-described embodiments, gases containing halogen groups were cited as an example of the hydrophilic second precursor gas, and gases containing alkyl groups and hydrogen groups were cited as an example of the hydrophobic second precursor gas. However, the present disclosure is not limited to these embodiments. For example, gases containing alkoxide groups, amino groups and others may be appropriately used as the hydrophilic second precursor gas, and gases containing cycloalkyl groups, phenyl groups, cyclopentadienyl groups and others may be appropriately used as the hydrophobic second precursor gas.

It is desirable to prepare recipes used for each processing individually based on the processing contents and to record and store them in the memory 121c via an electrical communication line or the external memory 123. Then, when initiating each processing, it is desirable for the CPU 121a to select an appropriate recipe from among the multiple recipes recorded and stored in the memory 121c based on the processing contents. This allows for the reproducible formation of various film types, compositions, film qualities, and film thicknesses on a single substrate processing apparatus. Further, it reduces the burden on operators, minimizes the risk of operational errors, and enables a quick initiation of each processing.

The aforementioned recipes may not be restricted to a case of preparing them by creating new ones, but may also be prepared by modifying existing recipes already installed in the substrate processing apparatus, for example. When modifying recipes, the modified recipe may be installed in the substrate processing apparatus via an electrical communication line or a recording medium containing the recipe. Further, existing recipes already installed in the substrate processing apparatus may be directly modified by operating the input/output device 122 of the existing substrate processing apparatus.

In the above-described embodiments, an example of forming a film by using a batch type substrate processing apparatus capable of processing multiple substrates at once is described. The present disclosure is not limited to the above-described embodiments, and for example, may be suitably applied even when forming a film by using a single-wafer type substrate processing apparatus capable of processing one or several substrates at once. Further, in the above-described embodiments, an example of forming a film by using a substrate processing apparatus equipped with a hot-wall type process furnace is described. The present disclosure is not limited to the above-described embodiments, and may also be suitably applied when forming a film using a substrate processing apparatus equipped with a cold-wall type process furnace. Further, in the above-described embodiments, an example of activating gases by heat is described. However, the present disclosure is not limited to this. For example, the present disclosure may also be suitably applied in cases where gases are activated by a plasma generated inside or outside the process chamber 201, or by irradiating the gases with electromagnetic waves using a lamp or other sources.

Even when using such a substrate processing apparatus, it is possible to perform each processing by using the same processing procedures and processing conditions as in the above-described embodiments and modifications, and to achieve the same effects as the above-described embodiments and modifications.

The above-described embodiments and modifications may be used in combination as appropriate. The processing procedures and processing conditions at this time may be the same as the processing procedures and processing conditions in the above-described embodiments and modifications, for example.

According to the present disclosure in some embodiments, it is possible to improve the uniformity of a film formed on a substrate surface.

While certain embodiments are described, these embodiments are presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A method of processing a substrate (200) comprising performing a first cycle of forming a layer containing a first element and a second element, the first cycle including performing:
(a) supplying a first precursor gas containing the first element to the substrate (200) including a recess on a surface of the substrate (200);
(b) supplying a first adsorption inhibitor gas to the substrate (200);
(c) supplying a second precursor gas containing the second element, different from the first element, to the substrate (200); and
(d) supplying a reactant gas to the substrate (200),
wherein a functional group formed on the substrate (200) in (a) and (b) inhibits adsorption of the second precursor gas on the substrate (200), and
wherein in at least a part of (c), the second precursor gas is supplied to the substrate (200) on which the first precursor gas and the first adsorption inhibitor gas are adsorbed.

2. The method of Claim 1, wherein an amount of the second precursor gas adsorbed on a deep side of the recess is greater than an amount of the first adsorption inhibitor gas adsorbed on the deep side of the recess.

3. The method of Claim 2, wherein an exposure amount of the second precursor gas is greater than an exposure amount of the first adsorption inhibitor gas.

4. The method of Claim 1, wherein an amount of the first adsorption inhibitor gas adsorbed on a deep side of the recess is less than an amount of the first precursor gas adsorbed on the deep side of the recess.

5. The method of Claim 4, wherein an exposure amount of the first adsorption inhibitor gas is smaller than an exposure amount of the first precursor gas.

6. The method of any one of Claims 1 to 5, wherein the reactant gas removes the functional group formed on the substrate (200) in (b) through a chemical reaction.

7. The method of any one of Claims 1 to 5, wherein a number of the second element is smaller than a number of the first element in the layer formed by the first cycle.

8. The method of any one of Claims 1 to 5, wherein an amount of the second precursor gas adsorbed on the substrate (200) is controlled by a processing condition in (a).

9. The method of any one of Claims 1 to 5, wherein a molecular radius of the first adsorption inhibitor gas is smaller than a molecular radius of the first precursor gas.

10. The method of any one of Claims 1 to 5, wherein in at least a part of (a), the first precursor gas is supplied to the substrate (200) on which the first adsorption inhibitor gas is adsorbed.

11. The method of any one of Claims 1 to 5, further comprising: (e) supplying a second adsorption inhibitor gas, different from the first adsorption inhibitor gas, to the substrate (200),
wherein in at least a part of (a), the first precursor gas is supplied to the substrate (200) on which the second adsorption inhibitor gas is adsorbed.

12. The method of any one of Claims 1 to 5, further comprising a second cycle comprising (a) and (d) but excluding (b).

13. A method of manufacturing a semiconductor device, comprising the method of Claim 1.

14. A substrate processing apparatus, comprising:
a first precursor gas supply system configured to supply a first precursor gas containing a first element;
a first adsorption inhibitor gas supply system configured to supply a first adsorption inhibitor gas;
a second precursor gas supply system configured to supply a second precursor gas containing a second element different from the first element;
a reactant gas supply system configured to supply a reactant gas; and
a controller (121) configured to be capable of controlling the first precursor gas supply system, the first adsorption inhibitor gas supply system, the second precursor gas supply system, and the reactant gas supply system, so as to perform a process including a first cycle of forming a layer containing the first element and the second element, the first cycle including performing:
(a) supplying the first precursor gas to a substrate (200) including a recess on a surface of the substrate (200);
(b) supplying the first adsorption inhibitor gas to the substrate (200);
(c) supplying the second precursor gas to the substrate (200); and
(d) supplying the reactant gas to the substrate (200),
wherein a functional group formed on the substrate (200) in (a) and (b) inhibits adsorption of the second precursor gas on the substrate (200), and
wherein in at least a part of (c), the second precursor gas is supplied to the substrate (200) on which the first precursor gas and the first adsorption inhibitor gas are adsorbed.

15. A program that causes, by a computer, a substrate processing apparatus to perform a process comprising a first cycle of forming a layer containing a first element and a second element, the first cycle including performing:
(a) supplying a first precursor gas containing the first element to a substrate (200) including a recess on a surface of the substrate (200);
(b) supplying a first adsorption inhibitor gas to the substrate (200);
(c) supplying a second precursor gas containing the second element, different from the first element, to the substrate (200); and
(d) supplying a reactant gas to the substrate (200),
wherein a functional group formed on the substrate (200) in (a) and (b) inhibits adsorption of the second precursor gas on the substrate (200), and
wherein in at least a part of (c), the second precursor gas is supplied to the substrate (200) on which the first precursor gas and the first adsorption inhibitor gas are adsorbed.
